# EUROPÄISCHE PATENTANMELDUNG

(11) **EP 2 447 978 A2**
(43) Veröffentlichungstag der Anmeldung: **02.05.2012**
(21) Anmeldenummer: 11009905.8
(22) Anmeldetag: 01.03.2006
(51) Int. Cl.: H01J 37/34, C23C 14/32

(54) **Arcquelle**

(30) Priorität: 24.03.2005 CH 518052005
(62) Teilanmeldung aus: 06705363.7
(71) Anmelder: Oerlikon Trading AG, Trübbach, 9477 Trübbach (CH)
(72) Erfinder: Ramm, Dr. Jürgen, 7304 Maienfeld (CH); Gstoehl, Oliver, LI-9496 Balzers (LI); Widrig, Benno, 7310 Bad Ragaz (CH); Lendi, Daniel, 9472 Grabs (CH)
(74) Vertreter: Rüfenacht, Philipp Michael

(57) **Zusammenfassung**

Die Erfindung betrifft eine Arcquelle mit einem Target und zumindest einer Gegenelektrode sowie einer am Targetangeschlossenen Stromversorgungseinheit. Die Stromversorgungseinheit umfasst zumindest eine erste gepulste Hochstromversorgung (18) sowie eine weitere Stromversorgung (13'), wobei zumindest die erste gepulste Hochstromversorgung (18) oder zumindest die weitere Stromversorgung (13') zwischen Target und einer das Target umfassenden Elektrode geschaltet ist.

## Beschreibung

### Technisches Gebiet

Die Erfindung betrifft eine Arcquelle gemäss dem Oberbegriff von Anspruch 1, 8 und 10.

### Stand der Technik

Das Pulsen von Arcquellen ist aus dem Stand der Technik schon länger bekannt, so beispielsweise beschreibt WO 02/070776 sehr allgemein das Pulsen von Funkenquellen, um verschiedene Superhartschichten u.a. TiSiN abzuscheiden.

In WO 03/057939 ist eine Funkenquelle beschrieben, bei der das Zünden des Funkens über eine gepulste Hochspannungsversorgung, die Speisung des Funkens über eine gepulste Hochstromversorgung erfolgt. Der Betrieb des Funkens erfolgt hier diskontinuierlich. Ausgangsmaterialien sind metallisch leitenden Kathoden, leitfähige Legierungen und zusätzlich Kohlenstoff, beziehungsweise verdampfbare Halbleiter. Die hier gezeigte Arcquelle ist jedoch auf Grund der sehr komplexen Geometrie des Targetkörpers, besonders für schwer zu bearbeitende Kathodenmaterialien aufwändig zu fertigen und teuer im Betrieb.

In US 6,361,663 wird eine Arcquelle mit einer Kathode aus elektrisch leitfähigem Material beschrieben, die gepulst bzw. moduliert gepulst mit Spitzenströmen von bis zu 5 kA und einem Basisstrom von beispielsweise 100 A betrieben wird. Auch diese Quelle ist auf Grund ihrer Bauweise mit magnetischem Tunnel und einer von der Kathode vollständig umgebenen Anode aufwändig zu fertigen und teuer im Betrieb.

Auch die Abscheidung von elektrisch isolierenden Schichten mittels kathodischer Funkenverdampfung ist bereits bekannt, so beschreibt US 5,518,597 die Herstellung solcher Schichten in einem reaktiven Prozess. Dabei werden die zu beschichtenden Oberflächen ausserhalb einer optischen Verbindung zur aktiven Targetoberfläche, die hier als Synonym zur Verdampfungsoberfläche der Kathode gebraucht wird, angeordnet. Nach Abpumpen wird der Prozessdruck mit Inertgas eingestellt. Während der Beschichtung wird der Sauerstoff in unmittelbarer Nähe der zu beschichtenden Oberfläche und zwar nur mit einer solchen Rate eingelassen, dass es während der Operation verbraucht wird und ein stabiler Druck aufrechterhalten werden kann. Dies deckt sich mit der auch aus anderen Dokumenten des Standes der Technik bekannten Ansicht, dass der Einlass des Reaktivgases in der Nähe des Substrates wichtig ist, um die Oxidation des Targets zu reduzieren und die Funkenentladung zu stabilisieren. Als zusätzliche Massnahme, um Prozessunterbrechungen durch einen unerwünschten Aufbau isolierender Schichten auf der Anode zu vermeiden, wird diese in US 5,518,597 bevorzugt auf einer Temperatur bei ca. 1200°C gehalten und muss, d.h. aufwendig, aus teurem Refraktärmetall gefertigt werden.

Die DE 44 01 986 A1 (VTD-Vakuumtechnik Dresden GmbH) beschreibt ein Verfahren zum Betreiben eines Vakuumlichtbogenverdampfers, wobei ein Grundstrom mit einem pulsierenden Strom überlagert wird, wodurch das Target gleichmässiger abgetragen und die Dropletbildung verringert wird. Dazu sind eine Gleichstromquelle für den Grundstrom und eine Pulsstromquelle für den pulsierenden Strom innerhalb der Stromversorgungseinrichtung parallel geschaltet, wobei die Gleichstromquelle und die Pulsstromquelle von einer Steuereinrichtung mit eingebautem Mikrorechner gesteuert werden. Es wurde festgestellt, dass der Grundstrom auf einen Wert abgesenkt werden kann, der unter jenem Wert liegt, der ohne pulsierenden Strom zur Aufrechterhaltung einer stabilen Bogenentladung erforderlich ist. Als Targetmaterial können Metalle der Gruppen IV, V und VI gewählt werden. In den Ausführungsbeispielen werden insbesondere Titan und Titan zusammen mit Aluminium als Targetmaterial gewählt, wobei Titan und Aluminium in koaxialen rotationssymmetrischen Bereichen angeordnet sind und die Abtragung in einer Stickstoff-Atmosphäre stattfindet.

Da in der DE 44 01 986 A1 nur leitende Schichten und keine isolierende Schichten aufgetragen werden, kann sich auf dem Target auch keine Isolierbelegung bilden. Das heisst, einen Betrieb im vergifteten Bereich ist nicht möglich. Daher geht aus der DE 44 01 986 A1 auch nicht hervor, welche Auswirkung eine Isolierbelegung auf dem Target für den Betrieb einer Arcquelle hat.

All diesen Verfahren ist gemeinsam, dass bei Verwendung von Reaktivgasen, die mit dem bzw. den verdampften Materialien rasch unter Bildung einer isolierenden Schicht reagieren, besondere Massnahmen zu treffen sind, um einerseits die aktive Oberfläche des Targets bzw. der Anode nicht zu vergiften, andererseits die Bildung von unerwünschten Droplets zu vermeiden. Solche Massnahmen umfassen, neben dem erwähnten Beheizen der Anode und der Zufuhr und genauen Dosierung des Reaktivgases in unmittelbare Nähe der zu beschichtenden Oberfläche, eine Verdünnung des Reaktivgases mit einem hohen Anteil an Inertgas.

Insbesondere ist dabei darauf zu achten, dass die Oberfläche des Targets metallisch blank oder zumindest eine einem Halbleiter entsprechende Leitfähigkeit behält. Durch den positiven Temperaturgradienten von Halbleitern ist im Bereich des Arcspots zwar eine ausreichend gute Leitfähigkeit vorhanden, um den Funken brennen zu lassen, jedoch kommt es durch die damit einhergehende erhöhte Neigung zum Festbrennen des Funkens üblicherweise zu einer höheren Spritzerbildung als bei metallisch leitenden Targetoberflächen. Auch dazu sind aus dem Stand der Technik eine Reihe von Möglichkeiten bekannt. Beispielsweise können die Quellen wie oben erwähnt ausserhalb der optischen Verbindungslinie zur Targetoberfläche angeordnet werden, was jedoch die Ausbeute des Targetmaterials bzw. die Beschichtungsrate drastisch einschränkt. Es können zusätzlich oder allein magnetische Felder angelegt werden, die nur den ionisierten Dampfanteil auf die zu beschichtenden Oberflächen leiten, während elektrisch neutrale Droplets auf Prallflächen abgefangen werden. Beispiele dafür sind gekrümmte Magnetfilter, magnetische Linsen und ähnliches.

Eine weitere Methode Spritzer zu reduzieren, besteht aus einem kurzzeitigen Unterbrechen der Stromzufuhr, wobei der Funken, beispielsweise über einen Laserstrahl gesteuert, jeweils an einem anderen Ort der aktiven Targetoberfläche wieder gezündet wird. Diese Methode wird vor allem im Gebiet der kathodischen Funkenverdampfung von Kohlenstoff aber auch für Legierungen aus Metall angewendet.

All diesen Massnahmen, bzw. den ebenso bekannten Kombinationen dieser Massnahmen, ist ein zusätzlicher beträchtlicher technischer Aufwand und/oder eine wesentliche Verringerung der Beschichtungsrate gemein. Kommt es jedoch auf der Targetoberfläche zur Ausbildung einer Isolierbelegung, so konnte bis jetzt auch mit oben angegebenen Massnahmen kein stabiler Prozess gefahren werden.

### Darstellung der Erfindung

Eine Aufgabe der vorliegenden Erfindung besteht daher darin, ein Verfahren zur Verfügung zu stellen, mit dem auch isolierende Schichten mit üblichen Arcquellen ohne aufwendige zusätzliche Massnahmen unter stabilen Prozessbedingungen hergestellt werden können.

Diese Aufgabe wird gelöst mit Hilfe einer Arcquelle nach Anspruch 1, 8 und 10. Weitere erfinderische Ausbildungen sind beschrieben in den Unteransprüchen, die einzeln oder gemeinsam, soweit technisch sinnvoll, kombinierbar sind.

Überraschenderweise konnte gezeigt werden, dass bei gleichzeitigern Anlagen eines Gleichstroms, der mit einem Puls- bzw. Wechselstrom überlagert ist, ein stabiler Arcprozess auch dann betrieben werden kann, wenn die Targetoberfläche zumindest teilweise durch eine Isolierbelegung bedeckt ist.

Beispielsweise konnte so ohne weitere zusätzliche Massnahmen ein Aluminiumtarget mehrere Stunden lang in einer reinen Sauerstoffatmosphäre betrieben werden. Dabei wurde ein Anstieg der Spannung am Target beobachtet, dieser Anstieg stabilisierte sich aber innerhalb Minuten und führte nicht zum Unterbruch oder zur Instabilität des Arcprozesses. Die dabei auf einem direkt vor dem Target positioniertem Substrat abgeschiedene Aluminiumoxidschicht zeigte eine gegenüber einer unter gleichen Bedingungen abgeschiedenen metallischen Aluminiumschicht völlig unerwartete deutliche Reduktion der Oberflächenfehler durch anhaftende Droplets. Zu ähnlichen Ergebnissen führte auch der Betrieb von Chrom- bzw. Titantargets bzw. von metallischen Targets dieser Materialien mit hohem Siliziumanteil, sogar über 50%, in reiner Sauerstoff- oder reiner Stickstoffatmosphäre. In allen Fällen konnten die Targets nach einer vollständigen Isolierbelegung der Oberfläche auch nach Prozessunterbrechungen problemlos unter Reaktivgasatmosphäre wieder gezündet und mit verringerter Dropletbildung betrieben werden. Der Betrieb in reiner Reaktivgasatmosphäre bzw. mit der Belegung der Targetoberfläche durch das Reaktivgas bzw. dessen Reaktion mit der Targetoberfläche, führten in diesem Pulsmode zu erhöhter Schichtqualität mit verminderter Dropletbildung Gegenüber dem Betrieb der Targets ohne Isolierbelegung, konnte festgestellt werden, dass der Anteil des Reaktivgases zumindest so hoch gewählt werden sollte, dass die Quellenspannung im Vergleich zum Betrieb ohne Isolierbelegung um mindestens 10%, bevorzugt jedoch um mindestens 20% zunimmt. Der Anstieg der Quellenspannung ist grundsätzlich vom verwendeten Reaktivgas und dem Targetmaterial abhängig. Je höher die isoliereigenschaften der aus dem Targetmaterial und dem Reaktivgas an der Targetoberfläche hergestellten Verbindung bzw. Verbindungen ist, desto grösser wird üblicherweise die Differenz der Quellenspannung, auch wenn hier auf Grund zahlreicher Oberflächen- und materialspezifischer Reaktionsmuster bzw. -hemmungen nicht ohne Weiteres ein direkter mathematischer Zusammenhang herstellbar ist.

Als Reaktivgase sind dabei beispielsweise folgende Gase geeignet: Sauerstoff, Stickstoff, Acethylen, Methan, Silane wie z.B. Tetramethylsilan, Trimethylaluminium, Diboran bzw. grundsätzlich alle sauerstoff-, stickstoff-, Silizium-, bor- oder kohlenstoffhaltige Gase. Besonders geeignet ist dieses Verfahren für Prozesse mit hohen Reaktivgasflüssen, bei denen der Anteil des Reaktivgases grösser als der des Inertgases beispielsweise
über 70% insbesondere über 90% gewählt wird. Doch können auch wie oben erwähnt Prozesse in reiner, also 100% Reaktivgas enthaltender Atmosphäre vorteilhaft gefahren werden.

Als Targetmaterial kommen dabei grundsätzlich alle Materialien in Frage, die mit obengenannten Gasen auf der Oberfläche eines wie oben betriebenen Targets entsprechende lsolierbelegungen beispielsweise aus einem Oxid, Nitrid, Borid, Silizid, Carbid oder einer Mischung der erwähnten Verbindungen ausbilden. Für die Herstellung von Hartschichten, Barriereschichten, bzw. von dekorativen Schichten sind jedoch folgende Materialien besonders geeignet: Übergangsmetalle der IV, V, VI Nebengruppe bzw. Aluminium, Bor, Kohlenstoff oder Silizium bzw. eine Legierung oder Verbindung der vorgenannten Materialien, wie zum Beispiel TiAl, CrAl, TiAlCr, TiSi, TaSi, NbSi, CrSi, WC. Aber auch reine Materialien mit hohen Schmelzpunkten wie W, Ta, Nb und Mo lassen sich nach dieser Methode einfacher verdampfen.

Zur weiteren Verminderung der Spritzer, insbesondere beim Betrieb eines Targets unter sauerstoffhaltiger Atmosphäre, kann es, wie in US 6,602,390 offenbart, von Vorteil sein, dass das Targetmaterial aus einer einzigen kristallographischen Phase besteht.

Ein weiterer Vorteil aus dem gleichzeitigen Betreiben einer Arcquelle mit einem Gleichstrom sowie mit einem Puls- bzw. Wechselstrom ergibt sich beim Beschichten von temperaturempfindlichen Werkstücken, wie zum Beispiel gehärteten Stählen, Auslagerungslegierungen auf Bronze und Messingbasis, Aluminium-Magnesiumlegierungen, Kunststoffen und anderen. Bei einem DC-Betrieb einer oder mehrerer Arcquellen in der Nähe des Haltestroms, das ist der kleinste Strom bei dem noch ein stabiles Betreiben einer elektrisch leitenden Arcquelle mit einer einfachen DC-Stromversorgung möglich ist, ist die Temperaturbelastung der zu beschichtenden Werkstücke zwar gering, gleichzeitig aber die Beschichtungsrate für industrielle Anwendungen wenig befriedigend. Der Wert des Haltestroms bzw. der Halteleistung hängt dabei vom Targetmaterial, von der Bauart der Arcquelle bzw. vom Betrieb der Entladung ab, beispielsweise ob diese unter Vakuum mit oder ohne Zugabe von Inert- bzw. Reaktivgas betrieben wird. Eine ausreichende Leitfähigkeit, um einen stabilen Betrieb bei kleinen Strömen zu gewährleisten, haben beispielsweise metallisch blanke Oberflächen aber auch Verbindungen wie WC, TiN oder CrN. Graphit- bzw. Siliziumtargets bilden hier einen Grenzfall, da einerseits deren Leitfähigkeit zwar noch ausreicht um sie mittels DC-Arc zu verdampfen, andererseits dabei aber eine starke Tendenz zu einem lokalen Einbrennen des Funkens festzustellen ist, wodurch es zu Plasmaschwankungen und starker Dropletbildung kommt, weshalb beispielsweise Graphittargets heute bevorzugt gepulst betrieben werden.

Wird eine Quelle hingegen in der Nähe des DC-Haltestroms betrieben und gleichzeitig mit einem Pulsstrom überlagert, konnte überraschenderweise nicht nur die Rate wesentlich erhöht werden sondern auch die Temperaturbelastung gegenüber einer DC-Beschichtung mit vergleichbarer Rate gering gehalten werden: Vorteilhafterweise wird dabei der DC-Anteil bei 100 bis 300%, bevorzugt zwischen 100 bis 200% des Haltestroms, bzw. der Halteleistung eingestellt.

Ein solcher Prozentsatz des Haltestroms entspricht bei den wie unten näher beschriebenen Quellen einem DC-Anteil des Stromflusses in einem Bereich zwischen 30 und 90 A, bevorzugt zwischen 30 und 60 A. Dabei kann die Arcquelle prinzipiell ohne Prozessgas, bevorzugt aber mit einem Prozessgas, das nur Reaktivgas, nur Inertgas oder eine Mischung aus Reaktivgas und Inertgas enthält betrieben werden.

Als Targetmaterial kommen dabei grundsätzlich alle leitenden oder halbleitenden Materialien in Frage, bevorzugt aber die wie oben erwähnten.

Das Anlegen bzw. Erzeugen der verschiedenen Stromanteile kann dabei in bekannter Art und Weise erfolgen. Beispielsweise kann der Gleichstromanteil durch einen Gleichstromgenerator, der Puls- bzw. Wechselstromanteil durch eine Puls- bzw. Wechselstromgenerator erzeugt werden, wobei beide Generatoren entweder parallel oder in Serie zwischen Arcquelle und zumindest einer Anode bzw. Masse geschaltet werden.

Eine andere Möglichkeit ist es, den Gleich- und Pulsstromanteil durch zwei ebenso geschaltete, überlagert und synchronisiert betriebene Puls- bzw. Wechselstromgeneratoren zu erzeugen. Weiters ist es schliesslich auch möglich den Gleich- und Pulsstromanteil durch einen einzelnen Stromgenerator zu erzeugen, der sekundär oder primär getaktet wird.

Für industrielle Anwendungen ist ein solches Vorgehen besonders interessant, wenn beispielsweise Werkstücke, an die besondere Anforderungen betreffs Verschleissbeständigkeit gestellt werden, bzw. Werkstücke deren Oberfläche isolierende oder dekorative Eigenschaften aufweisen sollen, zu beschichten sind. Schichtbeispiele für die sich solche Verfahren besonders eignen sind Aluminiumoxid, Aluminiumnitrid, Aluminiumoxinitrid, Chromoxid, Chromnitrid, Chromoxinitrid, Aluminiumchromoxid, Aluminiumchromnitrid, Aluminiumchromoxinitrid, Aluminiumchromoxicarbonitrid, Siliziumoxid, Siliziumnitrid, Siliziumoxinitrid, Siliziumaluminiumoxid, Siliziumaluminiumnitrid, Siliziumaluminiumoxinitrid, Titansiliziumnitrid, Ti tansiliziumoxinitrid, Tantalsiliziumnitrid, Tantaloxid, Tantaloxintrid, Wolframsiliziumnitrid, Niobsiliziumnitrid, Titancarbid, Wolframkarbid, Wolframsiliziumkarbid bzw. Legierungen oder Verbindung der vorgenannten Materialien.

Die genannten Materialien können als Einzelschicht oder als eine Abfolge von zwei oder mehreren bezüglich der elementaren Zusammensetzung, der Stöchiometrie oder der kristallographischen Ausrichtung variierten Schichten abgeschieden werden, wobei die Schichtdicke der einzelnen Schichtlagen nach Bedarf zwischen wenigen Nanometern und einigen Mikrometern eingestellt werden kann. Zusätzlich können, wie dem Fachmann bekannt, beispielsweise metallische oder nitridische Haftschichten oder Anpassungsschichten aus unterschiedlichen Verbindungen, die beispielsweise einen gradierten Übergang vom Substratmaterial des Werkstücks zum Schichtmaterial ermöglichen, vor den oben angeführten Schichten abgeschieden werden. Bekannte Haftschichten sind beispielsweise Cr, Ti, CrN oder TiN. Anpassungsschichten werden unter Beispiel 1 aufgeführt.

Zusätzlich kann bei solchen Verfahren vorteilhaft ein DC-, ein Puls- oder ein Wechselstrombias angelegt werden, der bei Bedarf mit dem Puls- bzw. Wechselstromgenerator der Quelle synchronisiert wird.

Dabei können in bekannter Weise durch abwechselndes Zudosieren zumindest eines Inert-und zumindest eines Reaktivgases oder durch abwechselndes Zudosieren zumindest zweier Reaktivgase senkrecht zur Werkstückoberfläche Änderungen in der Schichtzusammensetzung und somit Zwei- oder Mehrschichtsysteme mit bei Bedarf gradiertem oder stufenförmigem Verlauf der Schichtzusammensetzung abgeschieden werden. Dazu können mehrere Quellen mit identischem oder unterschiedlichem Targetmaterial betrieben werden.

In ähnlich vorteilhafte Weise lässt sich ein wie oben beschriebenes Verfahren zum Betreiben eine Arcquelle ausnutzen, wenn eine Quelle zum Ätzen von Werkstückoberflächen verwendet wird, da hierbei die Oberfläche in wesentlich geringerem Ausmass mit Droplets belegt wird, als dies bei metallischen Targetoberflächen der Fall ist. Auch dabei wird ein DC-, ein Puls- oder ein Wechselstrombias an die Werkstücke angelegt, der allerdings meist deutlich höher als der bei der Beschichtung angelegte Bias ist. Beispielsweise können hier Substratspannungen zwischen -50 und -2000 V, bevorzugt zwischen -200 und -1500 V eingestellt werden. Zur Verstärkung des Ätzabtrags kann zusätzlich ein Ätzgas eingelassen werden, das beispielsweise folgende Komponenten enthält: He, Ar, Kr, Sauerstoff, Stickstoff, Wasserstoff, ein Halogen (z.B. Chlor, Fluor, Brom, Jod) oder eine halogenhaltige Verbindung.

Bei allen oben angeführten Verfahren kann die Beschichtungsrate bzw. der Energieeintrag in das Werkstück durch die Einstellung der Pulsbreite, des Strompulses, der Höhe des Strompulses oder durch das Tastverhältnis, bzw. durch eine Kombination dieser Parameter angepasst bzw. geregelt werden. Eine weitere Möglichkeit ist die Erhöhung des DC-Quellenstroms, die jedoch beispielsweise für Tieftemperaturprozesse wenig geeignet ist.

Als Werkstücke die für ein solches Beschichtungs- bzw. Ätzverfahren geeignet sind, kommen insbesondere Werkzeuge und Bauteile aus Stählen und Konstruktionsmetallen wie Kupfer- & Bleibronzen, Messing und Sonderlegierungen wie z.B. AlMg-Legierungen, Hartmetallen, aus keramischen Werkstoffen wie Bornitrid, insbesondere CBN, Cermet-Verbindungen bzw. entsprechende Werkstücken die zumindest teilweise mit Diamant- oder Keramikoberflächen bestückt sind.

Ein weiteres Anwendungsfeld für solche Verfahren ist die Beschichtung von Werkstücken aus Silizium oder anderen halbleitenden Materialen.

Es hat sich gezeigt, dass die Beschichtung im beschriebenen Pulsmode auch für isolierende Substrate geeignet ist, bei denen kein DC Substratbias bzw. ein DC gepulster Substratbias mit kleineren oder mittleren Frequenzen sinnvoll ist.

Mit einem wie oben beschriebenen Verfahren können schlagwortartig zusammengefasst folgende weitere vorteilhafte Wirkungen erzielt werden:
1. Ein stabiler Prozess zur Herstellung isolierender Schichten mittels Funkenverdampfung ohne dass es zu einer Spritzerbildung kommt, die eine Durchoxidation/-reaktion der Schicht verhindert.
2. Erstmals ist ein Arbeiten mit einem vollständig vergifteten Funkentarget möglich. Die Reaktivität, d.h. das Angebot der reaktiven Komponente, z.B. Sauerstoff bei der Abscheidung von Aluminiumoxid, kann durch das Arbeiten im voll vergifteten Mode bzw. in reiner Reaktivgasatmosphäre erhöht und damit einhergehend ein grösseres Schichtwachstum erzielt werden.
3. Es ist weder eine örtliche oder Druckstufentrennung von Target und Reaktionsraum noch eine aufwendige Trennung von Spritzern und ionisiertem Dampf notwendig.
4. Die Funkenführung kann ohne zusätzliche Magnetfeldunterstützung erfolgen.
5. Eine Reduktion der Zahl und Grösse der Spritzer auch bei vergiftetem Target.
6. Durch den modulierten Pulsbetrieb wird das Arbeiten mit höheren Strömen möglich, was zu einer grösseren lonisierung bei gleichbleibender oder sogar verringerter thermischer Belastung des Targets führt.
7. Kohlenstoff und halbleitende Materialien können ohne Neuzündung und aufwendige Funkenführung quasi spritzerfrei verdampft werden.
8. Ein gleichmässigerer Abtrag von leitenden, halbleitenden und nichtleitenden Targetoberflächen.
9. Eine feinere Aufteilung des Funkens, d.h. viele kleine und schnell über die Oberfläche laufende Arcspots.
10. Die Erzielung einer höheren Ionisierung durch Anwendung von Hochstrompulsen und damit verbundene Erhöhung des Substratstroms.
11. Die Prozessführung bei der reaktiven Funkenverdampfung wird unabhängig von der Targetbelegung durch isolierende oder halbleitende Schichten. Das erlaubt eine Mischung von Reaktivgasen und erlaubt das Fahren von Rampen bei reaktiven Prozessen, was sowohl bei der Zwischenschicht wie der Funktionsschicht von Vorteil ist.
12. Eine Erhöhung der Prozessstabilität und breiteres Prozessfenster.
13. Die Verwendung von bekannten Stromversorgungen, die einen weiten Bereich von Spezifikationen in Strom und Spannung zulassen (vielfältige ökonomische Kombinationen möglich, bspw. billige DC-Stromversorgung für Grundlast).
14. Die Erfindung stellt sicher, dass das Plasma nicht unterbrochen wird und damit das ein wiederholtes bzw. periodisches Neuzünden mit der erforderlich aufwendigen Technik nicht mehr erforderlich ist.
15. Eine Kombination des Verfahrens mit zusätzlichen Plasmaquellen ist möglich; hier sei insbesondere eine zusätzliche Anregung durch einen gleichzeitig betriebenen Niedervoltbogen erwähnt, womit eine zusätzliche Erhöhung der Reaktivität bei der Schichtabscheidung am Substrat erreicht wird.

### Wege zur Ausführung der Erfindung

Im Folgenden wird ein typischer Ablauf eines erfindungsgemässen Beschichtungsverfahrens mit einem reaktiven Funkenbeschichtungsprozess geschildert. Auf diese Weise wurden in einer industriellen Beschichtungsanlage vom Typ RCS der Firma Balzers, wie beispielsweise in EP 1 186 681 in Fig. 3 bis 6, Beschreibung Spalte 7, Zeile 18, bis Spalte 9, Zeile 25, beschrieben, entsprechend dem folgenden im Detail beschriebenen Beispiel Aluminiumoxid auf verschiedenen Werkstücken abgeschieden.

Neben dem eigentlichen Beschichtungsprozess wird, wo notwendig, auch kurz auf weitere Prozessschritte eingegangen, die die Vor- -und Nachbehandlung der Substrate betreffen. Viele dieser Schritte, wie beispielsweise die Reinigung der Substrate, die je nach Material und Vorbehandlung verschieden durchgeführt wird, lassen, wie dem Fachmann bekannt, breite Variationen zu, einige können unter bestimmten Bedingungen auch weggelassen, verkürzt, verlängert oder anders kombiniert werden.

### Beispiel 1

Nach Einlegen der Werkstücke in dafür vorgesehenen zwei- oder dreifach rotierbare Halterungen und Einbringen der Halterungen in die Vakuumbehandlungsanlage, wird die Behandlungskammer auf einen Druck von ca. 10⁻⁴ mbar abgepumpt.

Zur Einstellung der Prozesstemperatur wurde ein durch Strahlungsheizungen unterstütztes Niedervoltbogen(NVB)plasma zwischen einer durch eine Blende abgetrennte Kathodenkammer mit Heisskathode und den anodisch geschalteten Werkstücken in einer Argon-Wasserstoffatmosphäre gezündet.

Dabei wurden folgende Heizparameter eingestellt:

| | |
|---|---|
| Entladestrom NVB | 150 A |
| Argonfluss | 50 sccm |
| Wasserstofffluss | 300 sccm |
| Prozessdruck | 1.4x10⁻² mbar |
| Substrattemperatur | ca. 500°C |
| Prozesszeit | 45 min |

Alternativen dazu sind dem Fachmann bekannt. Die Substrate wurden dabei bevorzugt als Anode für den Niedervoltbogen geschaltet und bevorzugt zusätzlich unipolar oder bipolar gepulst.

Als nächster Prozessschritt wird das Aetzen gestartet. Dafür wird der Niedervoltbogen zwischen dem Filament und der Hilfsanode betrieben. Auch hier kann eine DC, eine gepulste DC oder eine mit Wechselstrom betriebene MF oder RF Versorgung zwischen Werkstücken und Masse geschaltet werden. Bevorzugt wurden die Werkstücke aber mit einer negativen Biasspannung beaufschlagt.

Dabei wurden folgende Ätzparameter eingestellt:

| | |
|---|---|
| Argonfluss | 60 sccm |
| Prozessdruck | 2.4x10⁻³ m bar |
| Entladestrom NVB | 150 A |
| Substrattemperatur | ca. 500°C |
| Prozesszeit | 30 min |

Um die Stabilität der Niedervoltbogenentladung bei der Herstellung isolierender Schichten zu gewährleisten, wird bei allen NVB-unterstützten Prozessschritten entweder mit einer heissen, leitfähigen Hilfsanode gearbeitet oder eine gepulste Hochstromversorgung zwischen Hilfsanode und Masse geschaltet.

Zur Erhöhung der Haftfestigkeit wird eine ca. 300 nm dicke CrN Schicht mittels Funkenverdampfung aufgebracht, die bei Bedarf an zusätzlicher Ionisation noch durch das Plasma des Niedervoltbogens unterstützt werden kann.

Dabei wurden folgende Zwischenschichtparameter eingestellt:

| | |
|---|---|
| Argonfluss | 80 sccm |
| Stickstofffluss | 200 sccm |
| Prozessdruck | 8x10⁻³ mbar |
| DC Quellenstrom Cr | 140 A |
| Substratbias | von -100V auf -40V bipolar 36 µs negativer und 4 µs positiver Bias |
| Substrattemperatur | ca. 500°C |
| Prozesszeit | 10 min |

Für den ca. 5 min langen Übergang zur eigentlichen Funktionsschicht werden die Aluminium-Arcquellen mit einem DC-Quellenstrom von 60 A zugeschaltet, wobei der positive Pol der DC-Quelle mit dem Anodenring und Masse verbunden ist. Zusätzlich erfolgt eine Ueberlagerung mit unipolaren DC Pulsen einer zweiten, parallel geschalteten Stromversorgung, die mit 50 kHz betrieben wird. Im vorliegenden Beispiel wurde mit einem symmetrischen Tast/Pauseverhältnis von 10 µs Puls/10 µs Pause gearbeitet und in den Pulsen Ströme bis 150 A generiert. Dann erfolgt der Einlass des Sauerstoffs mit 300 sccm, bzw. gemäss den in der Tabelle angegebenen Parametern.

Nach Hochfahren der Al Targets und Einstellen des Sauerstoffflusses, wird der Quellenstrom am Cr Target über eine Rampe in ca. 10 min auf Null zurückgefahren und gleichzeitig der N₂ Fluss reduziert. Anschliessend wird der Ar Fluss auf Null gefahren

Die Beschichtung der Substrate mit der eigentlichen Funktionsschicht erfolgt im reinen Reaktivgas (in diesem Fall Sauerstoff). Da es sich bei Aluminiumoxid um isolierende Schichten handelt, wird entweder eine gepulste oder AC Biasversorgung verwendet.

Die wesentlichen Funktionsschichtparameter wurden dabei wie folgt eingestellt:

| | |
|---|---|
| Sauerstofffluss | 300 sccm |
| Prozessdruck | 9x10⁻³ mbar |
| DC Quellenstrom Al | 60 A |
| Puls-Quellenstrom Al | 150 A, 50 kHz, 10 µs Puls/ 10 µs Pause |
| Substratbias | bleibt auf -40 V DC gepulst oder AC (jeweils 50 - 350 kHz) |
| Substrattemperatur | ca. 500°C |
| Prozesszeit | 60 bis 120 min, einzelne Versuche mit 360 min |

Die Beschichtung kann auch simultan mit gezündetem Niedervoltbogen erfolgen. In diesem Falle wird eine höhere Reaktivität erzielt. Ausserdem hat die simultane Benutzung des Niedervoltbogens während der Beschichtung auch noch den Vorteil, dass der DC Anteil der Quellen, je nach Grösse des NVB-Stroms weiter reduziert werden kann.

Der so geführte Beschichtungsprozess ist stabil über mehrere Stunden. Das Target bedeckt sich mit einer dünnen, glatten Oxidschicht. Der Funken läuft ruhiger als bei einem Betrieb ohne zusätzliches Pulssignal und teilt sich in mehrere kleinere Funken auf. Die Spritzerzahl wird wesentlich reduziert.

Als Arcquellen wurden für die Haftschicht ebenso wie für die Funktionsschicht, Arcquellen der Firma Balzers mit einem Targetdurchmesser von 160 mm und einer Dicke von 6 mm, mit einem Standard MAG 6-Magnetsystem verwendet. Prinzipiell kann jedoch jede bekannte Quelle mit einem solchen Prozess gefahren werden, sofern eine entsprechende Stromversorgungseinheit angeschlossen wird.

Der beschriebene Prozess ist die bevorzugte Version, da er die Anforderungen an die gepulste Stromversorgung gering hält. Die DC-Versorgung liefert den Mindest- oder Haltestrom für den Funken und die gepulste Hochstromversorgung dient zur Vermeidung der Spritzer.

Weitere Beispiele für die Abscheidungsparameter von Funktionsschichten sind in Tabelle 1 näher beschrieben. Zunächst wurden im Wesentlichen dieselben Reinigungs, Heiz- und Ätzschritte vorgenommen, sowie eine Zwischenschicht aus CrN bzw. TiN entsprechend Beispiel 1 abgeschieden. Anschliessend wurden die Funktionsschichten aus Aluminiumoxid, Aluminiumnitrid, Chromoxid, Chromnitrid, Titanoxid sowie Titannitrid entsprechend den Angaben in der Tabelle hergestellt.

Zum Vergleich des Einflusses der Quellenspannung durch die Bedeckung mit einer Isolierbelegung wurde in Beispielen 2 und 8 eine rein metallische Schicht abgeschieden. Dabei zeigt sich, dass es vor allem bei einer Belegung mit hochisolierenden oxydischen Schichten zu einem starken Anstieg des DC-Anteils der Quellenspannung kommt. Hier beträgt der relative Spannungsanstieg schon bei verhältnismässig geringen Zugaben an sauerstoffhaltigem Reaktivgas zwischen ca. 20 und 50% des Werts der unter reinem Inertgas betriebenen metallisch blanken Quelle.

Auch bei einem Betrieb mit Stickstoff kommt es zu einem Anstieg der Quellespannung, der jedoch geringere Werte, etwa zwischen ca. 10 und maximal 30%, aufweist. In allen Fällen kommt es zwar durch das gleichzeitige Anlegen einer Pulsspannung zu einer geringfügigen Absenkung der DC-Quellenspannung gegenüber dem reinen DC-Betrieb, der ursprüngliche niedrigere Spannungszustand einer metallisch blanken Quelle wird jedoch in keinem Fall wieder erreicht.

Der bevorzugte Frequenzbereich in dem die Arcquelle betrieben wird liegt ist zwischen 5 und 50 kHz. Bei Bedarf kann die Quelle aber auch bei niedrigeren Frequenzen etwa bis 0,5 kHz, oder hohen Frequenzen bis 1 MHz betrieben werden. Bei noch niedrigeren Frequenzen wird der Betrieb bei der Abscheidung von isolierenden Schichten instabil, bei höheren Frequenzen steigen die Generatorkosten extrem an.

Sind zusätzliche Anpassungsschichten erwünscht oder notwendig, so können diese statt der CrN- oder anderen Haftschichten bzw. zwischen Haftschicht und Funktionsschicht aufgebracht werden. Beispiele dafür, die neben den bereits erwähnten auch bei der Abscheidung von oxydischen Deckschichten vorteilhaft sein können, sind die Oxykarbide von Titan und Chrom, sowie die Oxynitride, Oxysilicide, Oxysiliconitride, bzw. Siliconitride von Aluminium, Chrom, Titan, Tantal, Niob oder Zr.

Trotz der hervorragenden Haftfestigkeit von mittels kathodischer Funkenverdampfung hergestellten Haft bzw. Anpassungsschichten, können diese wie dem Fachmann bekannt auch mittels anderer Beschichtungstechniken wie zum Beispiel CVD, PECVD, Sputtern oder der Verdampfung mittels Niedervoltbogen aus einem anodisch geschaltetem Tiegel, erfolgen. Hier ist prinzipiell jede Kombination verschiedener Techniken möglich wobei jedoch plasmaunterstützte Prozesse, die eine hohe Ionisation gewährleisten, auf Grund der damit erzielbaren besseren Haftung bevorzugt sind.

### Kurze Beschreibung der Zeichnungen

Im Folgenden wird die Erfindung anhand von Figuren, welche lediglich verschiedene Ausführungsbeispiele darstellen, näher erläutert. Es zeigen
- Fig.1: eine Vakuumbehandlungsanlage mit Arcquelle
- Fig.2: parallel geschaltete DC- & Pulsstromversorgung
- Fig. 3: Targetoberflächen
- Fig.4: zwei parallel geschaltete Pulsstromversorgung
- Fig.5: eine Multianodenanordnung
- Fig.6: Stromversorgungen in Serienschaltung
- Fig.7: Stromversorgungen mit Kurzschiussschaltung
- Fig.8: eine sekundär getaktete Stromversorgung
- Fig.9: eine primär getaktete Stromversorgung

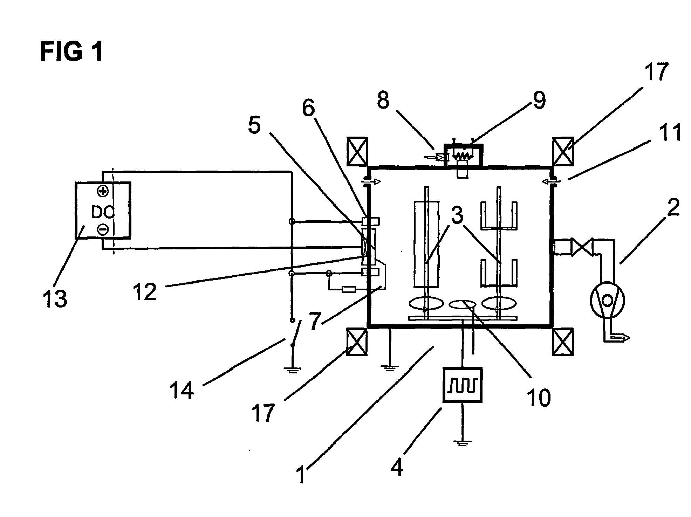

Die in Fig.1 dargestellte Vakuumbehandlungsanlage 1 zeigt vergleichsweise eine aus dem Stand der Technik bekannte Anordnung zum Betreiben einer Arcquelle mit einer DC-Stromversorgung 13. Die Anlage 1 ist mit einem Pumpstand 2 zum Erstellen des Vakuums, Substrathalterungen 3 zum Aufnehmen und elektrischen Kontaktieren der hier nicht näher dargestellten Werkstücke, sowie einer Biasstromversorgung 4, zum Anlegen einer sogenannten Substratspannung an die Werkstücke ausgerüstet. Letztere kann eine DC-, eine AC- oder eine bi- bzw. unipolare Substratspannungsversorgung sein. Über einen Prozessgaseinlass 11 kann Inert- bzw. Reaktivgas eingelassen werden, um Prozessdruck und Gaszusammensetzung in der Behandlungskammer zu steuern.

Bestandteile der Arcquelle selbst sind ein Target 5 mit dahinterliegender Kühlplatte 12, ein Zündfinger 7 sowie eine das Target umfassenden Anode 6. Mit einem Schalter 14, kann zwischen einem floatenden Betrieb der Anode und des positiven Pols der Stromversorgung 13 und einem Betrieb mit definiertem Null- bzw. Massepotential gewählt werden.

Weitere fakultative Merkmale der Vakuumbehandlungsanlage 1 sind eine zusätzliche Plasmaquelle 9, in diesem Fall eine Quelle zur Erzeugung eines NVB mit Heisskathode, mit Inertgaseinlass 8, eine Hilfsanode 10, sowie einer hier nicht näher dargestellten weiteren Stromversorgung zum Betreiben des Niedervoltbogens zwischen Plasmaquelle 9 und Hilfsanode 10, und bei Bedarf Spulen 17 zur magnetischen Bündelung des Niedervoltbogenplasmas.

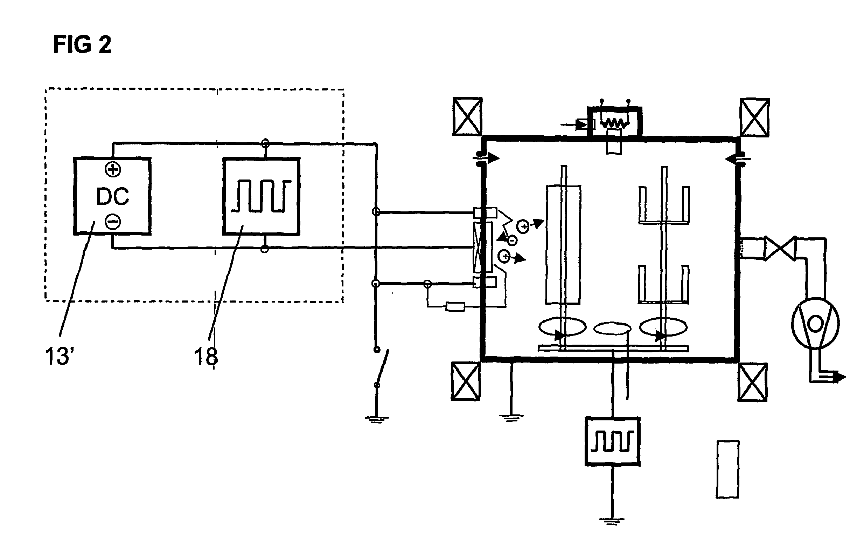

In Fig.2 ist eine Arcquelle dargestellt, die mit zwei parallel geschalteten Stromversorgungen, nämlich einer DC Stromversorgung 13' und einer gepulsten Hochstromversorgung 18, betrieben wird, um den Gleichstrom mit einem unipolaren oder bipolaren Pulssignal zu überlagern. Diese Beschaltung erlaubt einen stabilen Betrieb einer reaktiven Funkenverdampfung auch für isolierende Schichten, bei denen sich im Zeitverlauf das Innere der Anlage 1, die Hilfsanode 10 und die Substrathalterungen 3 mit Substraten mit einer isolierenden Schicht belegen.

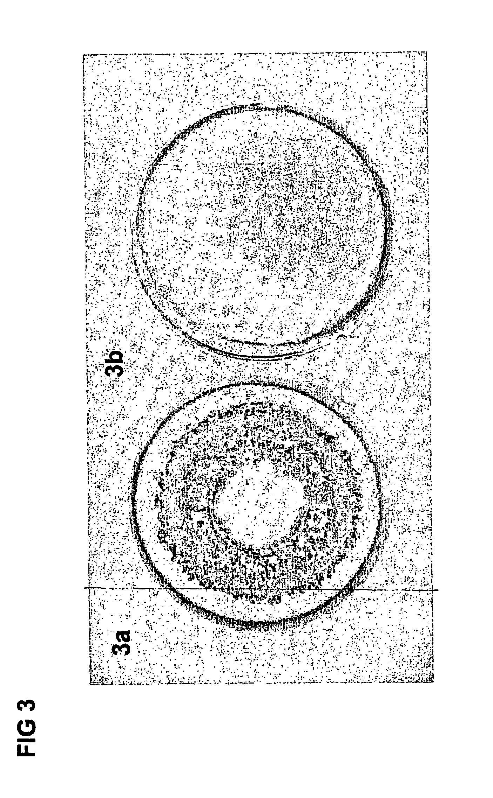

Wird vergleichsweise ein Target 5 aus reinem Aluminium in einer argon- und sauerstoffhaltigen Atmosphäre lediglich mit einer DC-Stromversorgung 13 gemäss Fig.1 betrieben, kommt es bereits nach wenigen Minuten zu Prozessinstabilitäten die bei hohem Sauerstofffluss zum Prozessabbruch führen. Dabei bildet sich auf dem Target 5 eine wie in Fig.3a dargestellte Belegung mit mehreren Millimeter grossen Inseln aus isolierendem Material. Die auf den Werkstückoberflächen abgeschiedenen Schichten werden sehr rauh und nicht vollständig isolierend, da es offenbar nicht zu einer durchgehenden Reaktion der vielen metallischen Spritzer kommt. Wird hingegen ein Target 5 in sauerstoffhaltiger Atmosphäre unter sonst gleichen Bedingungen mit einem erfindungsgemässen Verfahren wie in Fig.2 betrieben, bildet sich eine isolierende aber völlig gleichmässige Aluminiumoxidoberfläche wie in Fig.3b gezeigt. Der Prozess kann über Stunden geführt, unterbrochen und mit solcherart vergiftetem Target wiederaufgenommen werden. Gleichzeitig kommt es zu einer wesentlichen Reduktion der Spritzer auf der Werkstückoberfläche.

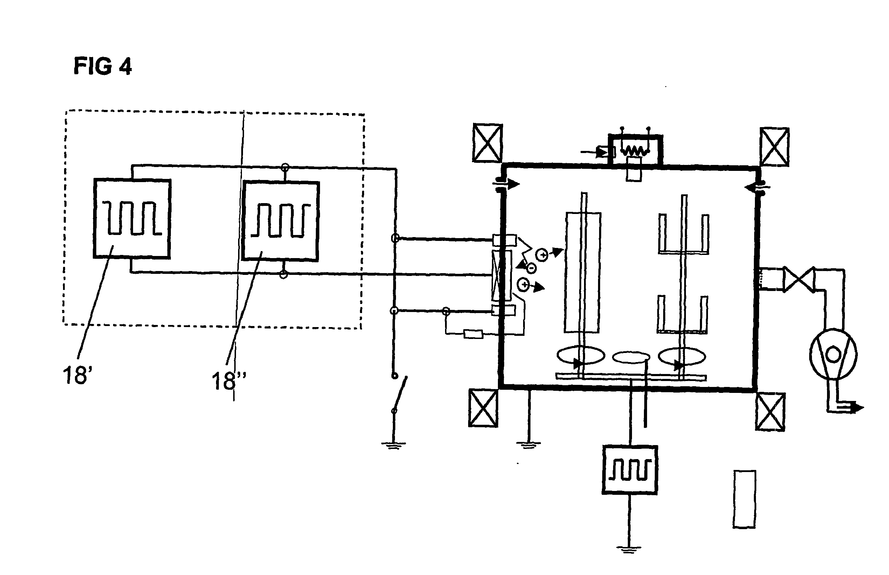

Im Folgenden werden weitere Möglichkeiten und Anordnungen zum pulsmodulierten Betreiben einer Arcquelle angeführt. Fig.4 zeigt die Parallelschaltung zweier bevorzugt synchronisiert gepulster DC Stromversorgungen 18' und 18". Diese Anordnung hat beispielsweise im unipolaren Betrieb eine Reihe von Vorteilen. So kann bei einem Betrieb mit gleicher Pulsbreite die Zeit zwischen zwei Pulsen sehr kurz gewählt werden, womit auch ein entsprechend grosses Tastverhältnis bzw. eine sehr kurze Zyklusdauer einstellbar ist. Durch die damit verbundene Möglichkeit die Energiezufuhr pro Puls, beispielsweise auch in Abstimmung auf das spezifische Targetmaterial, zu begrenzen, kann ein Festbrennen des Funkens sehr wirkungsvoll vermieden und einer Spritzerbildung weiter entgegengewirkt werden. Aber auch bei unipolarem Betrieb mit unterschiedlichen Pulsbreiten und verschiedenen oder gleichen Frequenzen, ermöglicht ein solcher Betrieb eine besonders gute Einstellung der einzelnen Zyklusphasen und damit eine sehr gute Kontrolle der Beschichtungsrate. Prinzipiell können gepulsten DC Stromversorgungen auch durch günstigere Wechselstromversorgungen ersetzt werden. Allerdings ist es dabei beispielsweise schwieriger, Signale einer bestimmten Form und Flankensteilheit zu erzielen.

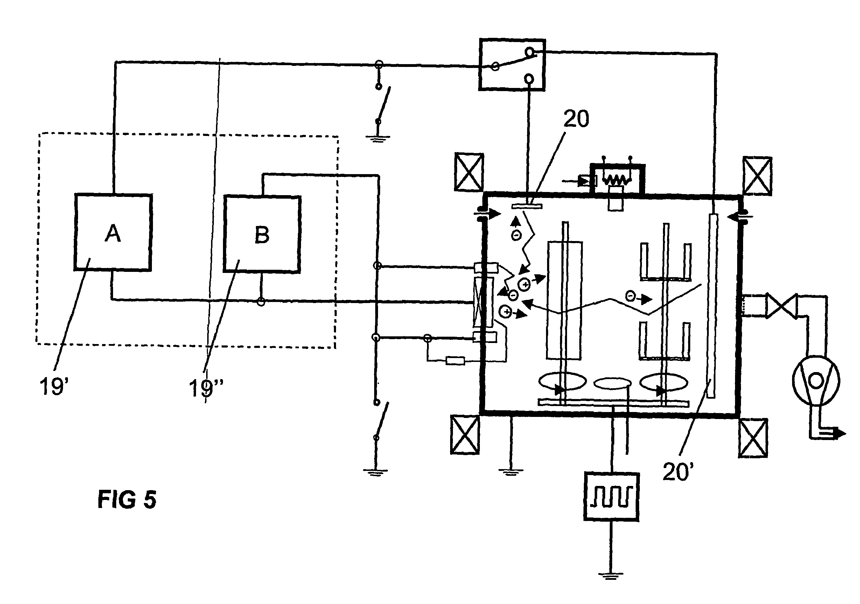

Gleichzeitig ermöglicht das Konzept zweier Stromversorgungen 19, 19" besonders vorteilhaft, wie in Fig.5 gezeigt, die Platzierung mehrerer Anoden 20, 20' zu einer besseren Verteilung des Plasmas in der Beschichtungskammer. Damit können die Elektronen besser geführt und damit die Plasmadichte und Reaktivität des Prozesses erhöht werden.

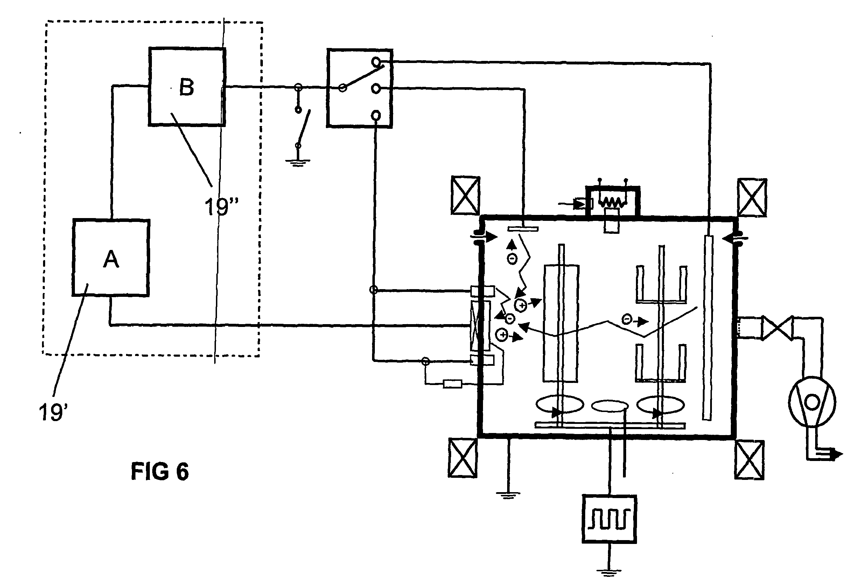

In Fig.6 wird eine Arcquelle dargestellt, die durch zwei in Serie geschaltete Stomversorgungen 19', 19", von denen zumindest eine eine Puls- bzw. AC-Versorgung ist, gespeist wird. Mit dieser Anordnung kann eine Anpassung der Rateregelung der Arcquelle besonders leicht realisiert werden.

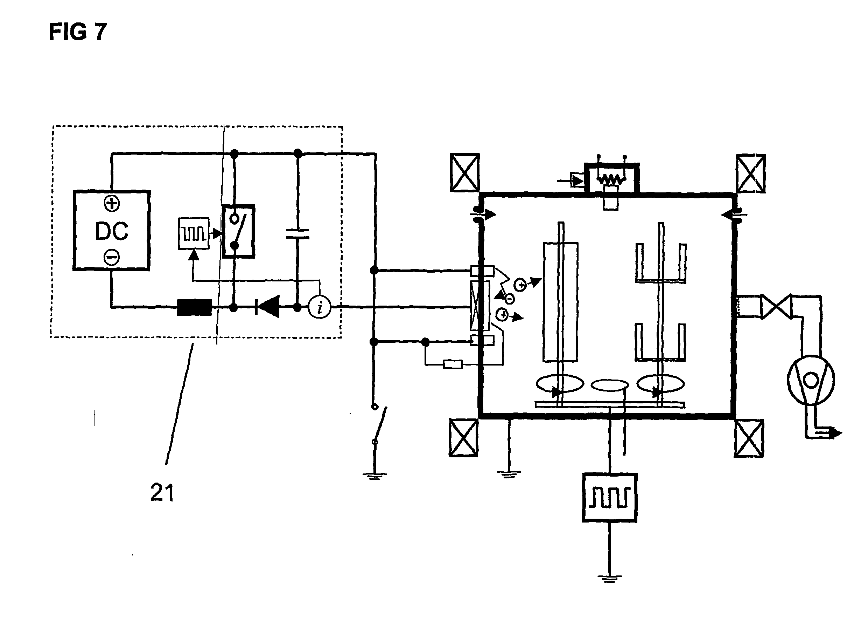

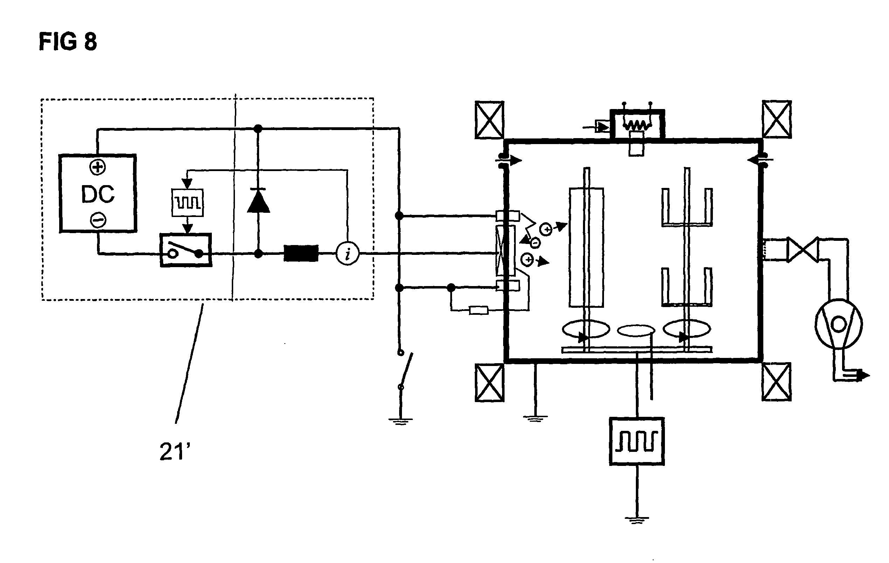

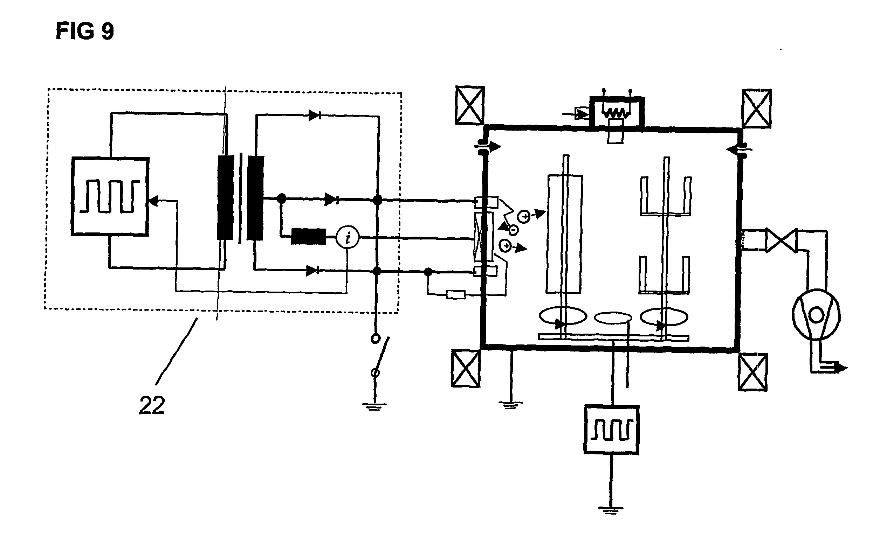

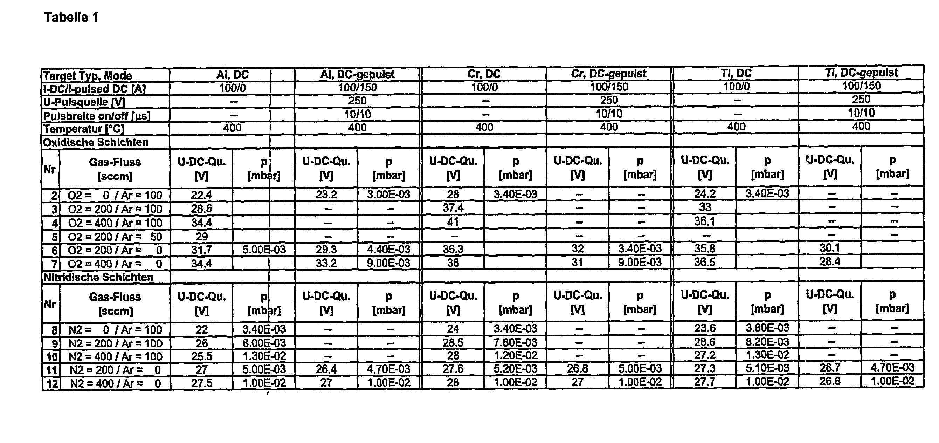

Die weiteren Ausführungsbeispiele betreffen Stromversorgungen, bei denen der Pulsstrom oder der Gleichstromanteil mittels Schaltnetzteiltechnik erzeugt wird. Bei derartigen Stromversorgungen kann die sonst nicht erwünscht Welligkeit des resultierenden DC-Signals solcherart verstärkt werden, dass ein den oben beschriebenen Anforderungen entsprechendes Signal am Ausgang der Stromversorgung anliegt. Beispielsweise kann dabei, wie in Fig.7 schematisch dargestellt, eine sekundär getaktete Stromversorgung als Aufwärtswandler 21 oder wie in Fig.8 eine ebenfalls sekundär getaktete Stromversorgung als Abwärtswandler 21' verwendet werden. Fig.9 zeigt hingegen eine primär getaktete Stromversorgung 22 zur Erzeugung des gewünschten Signals.

Von allen Versorgungen mit Schaltnetzteiltechnik ist die in Fig.8 gezeigte Versorgung die, die mit dem geringsten technischen Aufwand zu realisierbar ist und wird d.h. bevorzugt angewendet.

### Bezugszeichenliste

- 1: Vakuumbehandlungsanlage
- 2: Pumpstand
- 3: Substrathalterung
- 4: Biasstromversorgung
- 5: Target
- 6: Anode
- 7: Zündfinger
- 8: Inertgaseinlass
- 9: Plasmaquelle
- 10: Hilfsanode
- 11: Prozessgaseinlass
- 12: Kühlplatte
- 13,13': DC Stromversorgung
- 14: Schalter
- 17: Magnetspulen
- 18,18',18": Pulsstromversorgung
- 19,19',19": Stromversorgung
- 20,20': Anode
- 21: Aufwärtswandler
- 21': Abwärtswandler
- 22: primär getaktete Stromversorgung

## Patentansprüche

1. Arcquelle mit einem Target (5) und zumindest einer Gegenelektrode (6, 20, 20') sowie einer am Target (5) angeschlossenen Stromversorgungseinheit, wobei die Stromversorgungseinheit zumindest eine erste gepulste Hochstromversorgung (18, 18') sowie eine weitere Stromversorgung (13', 18") umfasst, **dadurch gekennzeichnet, dass** zumindest die erste gepulste Hochstromversorgung (18, 18') oder zumindest die weitere Stromversorgung (13', 18") zwischen Target (5) und einer das Target umfassenden Elektrode (6) geschaltet ist.

2. Arcquelle nach Anspruch 1, **dadurch gekennzeichnet, dass** die Stromversorgungseinheit zusätzlich eine DC-Stromversorgung (13') umfasst, die zumindest zum Aufrechterhalten eines Haltestroms ausgelegt ist.

3. Arcquelle nach Anspruch 1, **dadurch gekennzeichnet, dass** die Stromversorgungseinheit zusätzlich eine zweite gepulste Hochstromversorgung (18") umfasst, die mit der ersten gepulsten Arcquelle so synchronisierbar ist, dass ein Haltstrom mit überlagertem Pulssignal einstellbar ist.

4. Arcquelle nach Anspruch 3, **dadurch gekennzeichnet, dass** die gepulsten Arcquellen (18', 18") so synchronisierbar sind, dass der Haltestrom in einzelnen oder allen Pulspausen eine oder mehrere Haltestrompausen aufweist, in denen keine Spannung am Target bzw. an der Elektrode anliegt, wobei die Haltestrompausen so kurz einstellbar sind, dass das Arcplasma in den Pausen nicht erlöscht.

5. Arcquelle nach Anspruch 4, **dadurch gekennzeichnet, dass** die Haltestrompausen zwischen 1 ns bis 1 µs, bevorzugt zwischen 1 und 100 ns einstellbar sind.

6. Arcquelle nach einem der Ansprüche 1 bis 5, **dadurch gekennzeichnet, dass** die erste gepulste Hochstromversorgungen (18, 18') und die weitere Stromversorgung (13', 18") parallel oder in Serie geschaltet sind.

7. Arcquelle nach einem der Ansprüche 1 bis 6, **dadurch gekennzeichnet, dass** zumindest die erste gepulste Hochstromversorgung (18, 18') oder zumindest die weitere Stromversorgung (13', 18") zwischen Target (5) und weiteren Elektroden (20, 20') geschaltet ist.

8. Arcquelle mit einem Target (5) und zumindest einer Gegenelektrode (6, 20, 20') sowie einer am Target (5) angeschlossenen Stromversorgungseinheit, insbesondere nach einem der Ansprüche 1 bis 7, **dadurch gekennzeichnet, dass** die Stromversorgungseinheit eine sekundär getaktete Stromversorgung (21, 21') ist, wodurch das Signal der sekundär getakteten Stromversorgung (21, 21') so moduliert wird, dass ein DC-Haltestrom anliegt, der mit einem Puls- oder AC-Signal überlagert ist.

9. Arcquelle nach Anspruch 8, **dadurch gekennzeichnet, dass** die sekundär getaktete Stromversorgung als Abwärtswandler (21') oder als Aufwärtswandler (21) ausgeführt ist.

10. Arcquelle mit einem Target (5) und zumindest einer Gegenelektrode (6, 20, 20') sowie einer am Target (5) angeschlossenen Stromversorgungseinheit, insbesondere nach einem der Ansprüche 1 bis 7, **dadurch gekennzeichnet, dass** die Stromversorgungseinheit eine primär getaktete Stromversorgung (22) ist, wodurch das Signal der primär getakteten Stromversorgung (22) so moduliert wird, dass ein DC-Haltestrom anliegt, der mit einem Puls- oder AC-Signal überlagert ist.
